# EUROPÄISCHE PATENTSCHRIFT

(11) **EP 2 391 431 B1**
(45) Veröffentlichungstag und Bekanntmachung des Hinweises auf die Patenterteilung: **04.12.2013**
(21) Anmeldenummer: 10701145.4
(22) Anmeldetag: 25.01.2010
(51) Int. Cl.: C09B 67/54, B01D 7/00

(54) **VERFAHREN UND VORRICHTUNG ZUR KONTINUIERLICHEN REINIGUNG EINES FESTSTOFFGEMISCHES DURCH FRAKTIONIERTE SUBLIMATION/DESUBLIMATION**
METHOD AND DEVICE FOR CONTINUOUS CLEANING OF A SOLID MIXTURE BY FRACTIONATED SUBLIMATION/DESUBLIMATION
PROCÉDÉ ET DISPOSITIF POUR LA PURIFICATION EN CONTINU D'UN MÉLANGE DE SOLIDES PAR SUBLIMATION/ANTI-SUBLIMATION FRACTIONNÉE

(30) Priorität: 27.01.2009 EP 09151409
(43) Veröffentlichungstag der Anmeldung: 07.12.2011
(73) Patentinhaber: BASF SE, 67056 Ludwigshafen (DE)
(72) Erfinder: LINSENBÜHLER, Markus, 67069 Ludwigshafen (DE); SACHWEH,Bernd, 67149 Meckenheim (DE); HALPAP, Jörg, 68167 Mannheim (DE); KARCHES, Martin, 67434 Neustadt (DE); RIEGER, Reinhold, 67591 Offstein (DE)
(86) Internationale Anmeldenummer: PCT/EP2010/050755
(87) Internationale Veröffentlichungsnummer: WO 2010/086276

(56) Entgegenhaltungen:
- EP-A1- 0 324 986
- EP-A1- 0 359 931
- WO-A1-2004/097955
- DE-A1-102004 033 320

## Beschreibung

Die Erfindung betrifft ein Verfahren und eine Vorrichtung zur kontinuierlichen Reinigung eines Feststoffgemisches, enthaltend ein Wertprodukt, durch Sublimation/Desublimation, insbesondere zur Gewinnung des Wertproduktes in Form von Nanopartikeln.

Ein Gebiet, auf welchem Nanopartikel hergestellt und eingesetzt werden, betrifft Pigmente, wie sie zur Farbgebung zum Beispiel in Lacken verwendet werden. Mit abnehmender Größe der Partikel wird bei Pigmenten zum Beispiel die Brillanz und die Farbstärke der Lacke verbessert.

Ein weiterer Bereich, bei welchem Nanopartikel eingesetzt werden, betrifft Katalysatoren. So wird mit abnehmendem mittlerem Partikeldurchmesser die Gesamtoberfläche des Katalysators bezogen auf die Masse vergrößert, woraus eine effektivere Wirkung des Katalysators resultiert.

Weiterhin kann durch den Einsatz von Nanopartikeln im Bereich der Pharmaprodukte oder Pflanzenschutzmittel die Bioverfügbarkeit dieser erhöht werden.

Bei Materialien, die in einem Herstellungsverfahren auf ein Substrat aufgedampft werden, ist es von Vorteil, wenn die Partikel sehr feinteilig vorliegen, damit sie schneller in die Gasphase überführt werden können und damit die thermische Belastung verringert werden kann.

Nanopartikuläre Feststoffe können durch verschiedene Verfahren hergestellt werden. Gängigerweise werden diese pulverförmigen Feststoffe durch Mahlschritte, Reaktionen in der Gasphase, in einer Flamme, durch Kristallisation, Fällung, Sol-Gel-Prozesse, im Plasma oder durch Desublimation erzeugt.

Als Nanopartikeln werden in bekannter Weise Feststoffe oder Flüssigkeitströpfchen mit einem Partikeldurchmesser < 1 µm oder auch < 10 µm, verstanden. Aufgrund ihrer Dimensionen weisen Nanopartikel Eigenschaften auf, die sich teilweise grundlegend von Eigenschaften jeweils derselben Substanz, die jedoch weniger fein verteilt vorliegt, unterscheiden.

Insbesondere sollten partikelförmige Wertprodukte in einer Reinheit, die für Elektronikanwendungen ausreichend ist, das heißt in so genannter Electronic-Grade-Reinheit zur Verfügung gestellt werden. Darunter wird im Allgemeinen verstanden, dass eine Obergrenze für Verunreinigungen im einstelligen ppm-Bereich, oder auch im ppb-Bereich, nicht überschritten werden darf.

Bekannt ist ein Verfahren zur diskontinuierlichen Aufreinigung von Feststoffen durch Sublimation/Desublimation in einem Gradientenofen der Fa. Creaphys, zur Gewinnung von ultrahochreinen Substanzen, die für Elektronikanwendungen, insbesondere in Solarzellen, geeignet sind.

Das Verfahren ist jedoch nicht zur Aufreinigung von Feststoffen im Großmaßstab einsetzbar.

Die DE A1 10 2004 033 320 beschreibt ein Verfahren und eine Vorrichtung zur Herstellung von Nanopartikein ausgehend von einer Rohsubstanz, die in die Gasphase übergeführt wird, Erzeugen von Partikeln, beispielsweise durch Abkühlen der gasförmigen Rohsubstanz und Aufbringen von elektrischer Ladung auf die Partikel während des Erzeugens derselben in eine Vorrichtung zur Erzeugung von Nanopartikeln.

In einer bevorzugten Ausführungsform kann zwischen dem Ofen, in dem die Rohsubstanz in die Gasphase übergeführt wird, und der Vorrichtung zur Herstellung von Nanopartikein ein erster Partikelabscheider angeordnet sein, worin nicht verdampfte Substanzen abgetrennt werden.

Demgegenüber wird im erfindungsgemäßen kontinuierlichen Verfahren das zu reinigende, das sublimierte Wertprodukt enthaltende Gasgemisch über einen Heißgasfilter geleitet, der schwerer als das Wertprodukt sublimierende Feststoffpartikel zurückhält, unter Erhalt eines Gasgemisches, aus dem die schwerer als das Wertprodukt sublimierenden Komponenten abgetrennt wurden und Abkühlen desselben auf eine Temperatur, bei der das Wertprodukt desublimiert.

Die EP A1 0 359 931 beschreibt ein Verfahren zur Trennung von dampfförmigen Schwermetallverbindungen von einem Trägergas und zur Desublimation derselben in einem Schmelzofen. Das Dokument gibt keinen Hinweise auf die Notwendigkeit der Abtrennung von nicht-sublimierten Feststoffpartikeln aus einem das sublimierte Wertprodukt erhaltenen Gasgemisch.

Die EP A1 0 324 986 beschreibt einen weiteren Apparat zur kontinuierlichen Abtrennung feiner Partikel durch Desublimation, unter Verwendung eines konischen Abscheidebehälters mit einer Neigung zwischen 10 und 45°C.

Es war Aufgabe der Erfindung, ein technisch einfach realisierbares Verfahren zur kontinuierlichen Reinigung eines Feststoffgemisches, das auch in großtechnischem Maßstab einsetzbar ist, zur Verfügung zu stellen, das eine hohe Produktqualität, insbesondere eine sehr homogene Partikelgrößenverteilung mit homogener Morphologie in hoher Reinheit, bei gleichzeitig hoher Raumzeitausbeute, gewährleistet.

Insbesondere war es Aufgabe der Erfindung, ein wie vorstehend definiertes Verfahren zur Gewinnung des Wertproduktes in Form von Nanopartikeln zur Verfügung zu stellen.

Die Lösung besteht in einem Verfahren zur kontinuierlichen Reinigung eines Feststoffgemisches, enthaltend ein sublimierbares Wertprodukt, demgegenüber leichter und schwerer sublimierbare Komponenten durch fraktionierte Sublimation/Desublimation in einem Heißwandrohrofen (1), mit Zuführen des Feststoffgemisches zusammen mit einem Inertgasstrom, in den das Feststoffgemisch über ein Dispergierorgan (2) dispergiert wird, an einem Ende des Heißwandrohrofens (1),
- Aufheizen des dispergierten Feststoffgemisches im Heißwandrohrofen (1) bei einer Temperatur, bei der das Wertprodukt sublimiert, unter Erhalt eines Gasgemisches, enthaltend schwerer als das Wertprodukt sublimierende Komponenten als Feststoffpartikel,
- Überleiten des Gasgemisches, enthaltend schwerer als das Wertprodukt sublimierende Komponenten als Feststoffpartikel über einen Heißgasfilter (3) mit geeigneter Porengröße, um die schwerer als das Wertprodukt sublimierenden Feststoffpartikel zurück-zuhalten,
- Abkühlen des Gasgemisches, aus dem die schwerer als das Wertprodukt sublimierenden Komponenten abgetrennt werden auf eine Temperatur, bei der das Wertprodukt desublimiert, und bei der die leichter als das Wertprodukt sublimierenden Komponenten noch nicht desublimieren unter Erhalt eines Gasgemisches, enthaltend das partikelförmige Wertprodukt und
- Abscheiden des gereinigten, partikelförmigen Wertproduktes aus dem abgekühlten Gasgemisch.

Es wurde gefunden, dass es möglich ist, partikelförmige Wertprodukte in hoher Reinheit auch in großtechnischem Maßstab zur Verfügung zu stellen, indem kontinuierlich, in einem einzigen Apparat, eine fraktionierte Sublimation/Desublimation durchgeführt wird.

Indem erfindungsgemäß in einem Abschnitt des Heißwandrohrofens, in dem eine geeignete Abscheidevorrichtung, das heißt ein Heißgasfilter mit geeigneter Porengröße angeordnet ist, in dem schwerer als das Wertprodukt sublimierende Komponenten aus dem zu reinigenden Feststoffgemisch abgetrennt werden, ist es möglich, Bedingungen zu gewährleisten, unter denen eine homogene Keimbildung erfolgt, die zu einem lockeren Produkt mit homogener Morphologie und sehr homogener Partikelgrößenverteilung führt.

Das Verfahren geht aus von einem Feststoffgemisch, das sublimierbares Wertprodukt enthält, und daneben leichter und schwerer sublimierbare Komponenten. Darüber hinaus kann das Feststoffgemisch auch weitere, nicht-sublimierbare Komponenten umfassen.

Das zu reinigende Feststoffgemisch wird einem Heißwandrohrofen, an einem Ende desselben, zugeführt. Vorteilhaft ist eine gleichförmige Verteilung des zugeführten Feststoffgemisches, indem die Zuführung über ein Dispergierorgan, bevorzugt über eine Dosierrinne, eine Zellenradschleuse, einen Bürstendosierer oder eine Spiralstrahlmühle, erfolgt.

Der Heißwandrohrofen ist vorteilhaft vertikal angeordnet und weist eine heiße Wand auf, die bevorzugt elektrisch, insbesondere mittels Heizdrähten, aufgeheizt ist. Der Heißwandrohrofen kann eine einzige Heizzone aufweisen. Bevorzugt ist ein Mehrzonenheißwandrohrofen, das heißt ein Heizwandrohrofen mit zwei, drei oder mehreren Heizzonen. Die zwei, drei oder mehreren Heizzonen können mit zwei oder mehreren Heizreglern, oder aber auch durch eine unterschiedlich enge Wicklung von Heizdrähten erreicht werden.

Das sublimierbare Wertprodukt ist insbesondere ein organischer Feststoff, bevorzugt ein organischer Feststoff in Electronic-Grade-Reinheit, weiter bevorzugt ein organisches Pigment.

Das Feststoffgemisch wird dem Heißwandrohrofen zusammen mit einem Inertgasstrom zugeführt, das heißt einem Gasstrom, mit dem die Komponenten des Feststoffgemisches chemisch nicht reagieren.

Zur Vermeidung einer kurzfristigen starken thermischen Beanspruchung des aufzureinigenden Feststoffgemisches durch Berührung mit den Wänden des Heißwandrohrofens, wird in einer bevorzugten Verfahrensvariante der das Feststoffgemisch enthaltende Inertgasstrom in einem Füllgasstrom umschlossen. Als Füllgas eignen sich ebenso wie als Inertgas Gase, die gegenüber dem aufzureinigenden Feststoffgemisch inert sind. Das Füllgas wird dem Heißwandrohrofen vorzugsweise über dessen Umfang, über Gaszuführdüsen, zugeführt. Bevorzugt können die Gaszuführdüsen so ausgerichtet sein, dass das Füllgas dem Heißwandrohrofen parallel zu seinen Wänden zugeführt wird, wobei vermieden wird, dass sich das Füllgas bereits am Eintritt vollständig mit dem das zu reinigende Feststoffgemisch enthaltenden Inertgas vermischt.

In einer weiteren bevorzugten Ausführungsform sind die Wände des Heißwandrohrofens aus einem porösen Sintermaterial ausgebildet, über das eine gleichmäßige Zuführung des Füllgases in den Heißwandrohrofen erreicht werden kann.

Um eine gleichmäßige Sublimation und eine gleichmäßige thermische Beanspruchung, insbesondere von thermolabilen Substanzen, zu erreichen, ist die Temperatur im Heißwandrohrofen vorzugsweise so geregelt, dass die niedrigste Temperatur höchstens 20 % niedriger ist als die höchste im Heißwandrohrofen auftretende Temperatur.

Der Heißwandrohrofen kann, insbesondere um eine temperaturschonende Behandlung von thermolabilen Substanzen zu gewährleisten, im Vakuum betrieben werden. Bei ausreichend kurzen Verweilzeiten kann der Heißwandrohrofen jedoch vorteilhaft auch bei einem Druck von etwa 1 bar absolut betrieben werden, wobei die Verweilzeiten, in Abhängigkeit von der Temperaturempfindlichkeit des aufzureinigenden Feststoffgemisches im Bereich von 0,1 bis 1 h, bevorzugt von 0,1 bis 100 s, weiter bevorzugt im Beriech von 0,5 bis 5 s, liegen.

Nach dem erfindungsgemäßen Verfahren können insbesondere Monomere, Oligomere oder Polymere aufgereinigt werden. Entsprechend kann das aufzureinigende Feststoffgemisch einen Sublimationspunkt oder auch einen Sublimationsbereich aufweisen.

Das aufzureinigende dispergierte Feststoffgemisch wird zunächst bis annähernd in den Sublimationsbereich oder annähernd bis zum Sublimationspunkt des Wertproduktes, bevorzugt bis auf etwa 5°C oberhalb oder unterhalb des Sublimationsbereiches oder oberhalb oder unterhalb des Sublimationspunktes des Wertproduktes, aufgeheizt.

Der Inertgasstrom, der nunmehr das Wertprodukt sowie demgegenüber leichter sublimierbare Komponenten in Dampfform, schwerer als das Wertprodukt sublimierbare Komponenten sowie nicht-sublimierbare Komponenten jedoch weiter in fester Form enthält, wird über einen Heißgasfilter geleitet, der mit einer geeigneten Porengröße ausgewählt wird, um die schwerer als das Wertprodukt sublimierenden Feststoffpartikel und gegebenenfalls die nicht-sublimierbaren Feststoffpartikel zurückzuhalten. Der Heißgasfilter ist ebenfalls auf eine Temperatur aufgeheizt die annähernd dem Sublimationsbereich oder dem Sublimationspunkt des Wertproduktes entspricht, bevorzugt etwa 5°C oberhalb oder unterhalb des Sublimationsbereiches oder oberhalb oder unterhalb des Sublimationspunktes des Wertproduktes.

Der Werkstoff für den Heißgasfilter muss daher entsprechend ausgewählt werden, so dass er, je nach Sublimationsbereich oder Sublimationspunkt des aufzureinigenden Wertproduktes, thermisch stabil ist. Als Werkstoff für den Heizgasfilter kommen insbesondere Metall, Keramik, Glasfasern, oder auch Kunststoff, insbesondere Polytetrafluorethylen, in Frage.

Die Funktion des Heißgasfilters kann auch durch einen anderen, dem Fachmann bekannten Abscheider durch Feststoffpartikel übernommen werden, insbesondere Heißgaselektrofilter, oder auch Zyklone.

Vorteilhaft wird durch entsprechende Regelung der Heizung sichergestellt, dass jeglicher Temperaturabfall im Bereich des Heißgasfilters vermieden wird.

Im weiteren Verlauf des Heißwandrohrofens, nach dem Heißgasfilter, kann vorteilhaft ein zentraler, mit der Spitze nach oben gerichteter Kegel angeordnet sein, um das beladene Inertgas an die Wand des Heißwandrohrofens zu leiten.

Nach dem Heißgasfilter und gegebenenfalls dem Kegel zur Strömungsführung, ist im Heißwandrohrofen ein Quenchbereich angeordnet, worin die Abkühlung des Gasgemisches, aus dem die schwerer als das Wertprodukt sublimierenden Komponenten im Heißgasfilter abgetrennt wurden, auf eine Temperatur erfolgt, bei der das Wertprodukt desublimiert und bei der die leichter als das Wertprodukt sublimierenden Komponenten noch nicht desublimieren, unter Erhalt eines Gasgemisches, enthaltend das gereinigte, partikelförmige Wertprodukt. Dieses wird in einem nächsten Verfahrensschritt aus dem abgekühlten Gasgemisch abgeschieden.

Die Abkühlung erfolgt bevorzugt sehr schnell, das heißt bei einer Verweilzeit < 0,1 s bis < 100 s, insbesondere über einen Gasquench oder eine Laval-Düse.

Die Abkühlung erfolgt bevorzugt in einem Gasquench, insbesondere auf Umgebungstemperatur, wobei das Massenverhältnis zwischen dem mit den Komponenten des Feststoffgemisches beladenen Inertgas und dem Quenchgas vorteilhaft im Bereich zwischen 1 : 5 und 1 : 10 eingestellt wird.

Je nach Anforderungen, kann die Abkühlung jedoch auch über einen längeren Zeitraum, in einem Verweilzeitbehälter, durchgeführt werden. Dies ist insbesondere bei hohen Anteilen an leicht sublimierbaren Substanzen vorteilhaft.

Das Abscheiden des gereinigten, partikelförmigen Wertproduktes aus dem Gasstrom erfolgt bevorzugt in einem Elektrofilter.

Das gereinigte, partikelförmige Wertprodukt kann noch durch Leichtsieder verunreinigt werden. Es ist daher bevorzugt, das gereinigte, partikelförmige Wertprodukt durch fraktionierte Sublimation/Desublimation von Leichtsiedern weiter zu reinigen, das heißt das Wertprodukt zu "entgasen".

In einer vorteilhaften Ausführungsvariante kann die Abkühlung des Gasgemisches, enthaltend schwerer als das Wertprodukt sublimierende Komponenten als Feststoffpartikel auf eine Temperatur, bei der das Wertprodukt in Gegenwart von inerten Träger-partikeln erfolgen. Die inerten Trägerpartikel können bevorzugt kugelförmig sein und weiter bevorzugt einen Durchmesser im einstelligen Millimeterbereich aufweisen. Durch Desublimieren des Wertproduktes auf inerten Trägerpartikeln wird insbesondere das Handling verbessert.

Die Abkühlung des Gasgemisches, enthaltend schwerer als das Wertprodukt sublimierende Komponenten, in Gegenwart von inerten Trägerpartikeln erfolgt bevorzugt bei einer Temperatur und einem Druck, die so geregelt werden, dass sich auf den inerten Trägerpartikeln eine Feststoffschicht des Wertproduktes mit einer Dicke im Bereich von 1 bis 200 µm, abscheidet.

Gegenstand der Erfindung ist auch ein Heißwandrohrofen zur kontinuierlichen Reinigung eines Feststoffgemisches, umfassend ein Wertprodukt, sowie demgegenüber leichter und schwerer sublimierbare Komponenten durch fraktionierte Sublimation/Desublimation
- mit einem Zuführstutzen für das Zuführen des Feststoffgemisches zusammen mit einem Inertgasstrom, in den das Feststoffgemisch über ein Dispergierorgan dispergiert wird, an einem Ende des Heißwandrohrofens,
- 1, 2, 3 oder mehreren Heizzonen zum Aufheizen des dispergierten Feststoffgemisches im Heißwandrohrofen bei einer Temperatur, bei der das Wertprodukt sublimiert, unter Erhalt eines Gasgemisches, enthaltend schwerer als das Wertprodukt sublimierende Komponenten als partikel,
- einem Heißgasfilter mit geeigneter Porengröße zum Überleiten des Gasgemisches, enthaltend schwerer als das Wertprodukt sublimierende Komponenten als Partikel, um die schwerer als der Wertstoff sublimierenden Partikel zurückzuhalten, und mit
- einem Gasquench, einer Laval-Düse oder einem Verweilzeitbehälter zum Abkühlen des Gasgemisches, enthaltend schwerer als das Wertprodukt sublimierende Komponenten als Feststoffpartikel auf eine Temperatur, bei der das Wertprodukt desublimiert, unter Erhalt des gereinigten, partikelförmigen Wertproduktes.

Bevorzugt ist das Dispergierorgan eine Spiralstrahlmühle, eine Dosierrinne, eine Zellenradschleuse oder ein Bürstenzudosierer ist.

Der Heißwandrohrofen ist an seinem Außenmantel bevorzugt elektrisch beheizt. Eine elektrische Heizung kann einfach und genau geregelt werden.

Bevorzugt ist der Heißgasfilter aus Metall, Keramik, Glasfasern oder Kunststoff, gebildet.

Die Erfindung wird im Folgenden anhand einer Zeichnung näher erläutert.

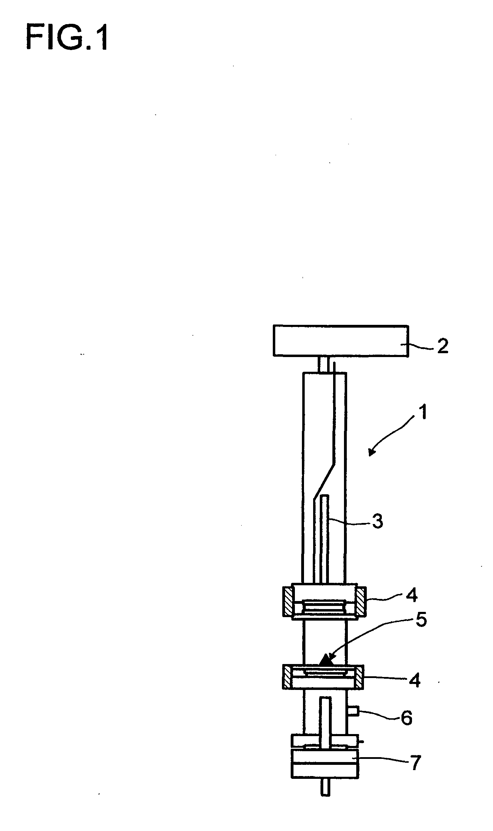

Die einzige Figur 1 zeigt einen vertikal angeordneten Heißwandrohrofen 1 mit Dispergierorgan 2 für die Zuführung des aufzutrennenden Feststoffgemisches zusammen mit einem Inertgasstrom.

Das im Inertgasstrom dispergierte Feststoffgemisch wird über einen Heißgasfilter 3 geleitet, der über einen Flansch 4 mit Heizmanschetten montiert ist, anschließend über einen Kegel 5 zur Steuerung der Gasströmung geleitet und in einem Gasquench mit Zuführungsstutzen 6 für das Quenchgas abgekühlt. Das gereinigte, partikelförmige Wertprodukt wird aus dem Inertgasstrom im Abscheider 7 abgetrennt.

### Ausführungsbeispiel

Mittels eines Bürstendosierers RBG^{®} 2000 der Fa. Palas wurden 200 g eines Verunreinigungen enthaltenden Kupferphthalocyanins (im Folgenden abgekürzt als CuPc bezeichnet) in ca. 6 h mit 1 m³/h Stickstoff kontinuierlich in einen vertikal durchströmten Heißwandreaktor (Innendurchmesser 40 mm, Länge 1.200 mm) dosiert.

Der Anlageninnendruck lag bei 1,1 bar absolut.

Mittels eines 6-zonigen Ofens der Fa. HTM Reetz wurde eine konstante Temperatur von 500 °C über die gesamte Ofenlänge im Heißwandreaktor eingestellt. Der verunreinigte Sublimatstrom wurde mittels 4 parallelen Sintermetallkerzen mit einer Länge von 300 mm und einem Außendurchmesser von 10 mm, die sich 150 mm vor dem Gasaustritt aus dem Heißwandreaktor befanden, aufgereinigt.

Durch Einleiten von 1 m³/h Stickstoff nach dem Heißwandreaktor wurde die Temperatur des Gasstromes unter die Desublimationstemperatur abgesenkt und anschließend das desublimierte Wertprodukt aus dem Gasstrom in einem Elektrofilter abgeschieden.

Farbtests mit dem aufgereinigten Material zeigten eine um 10 % höhere Farbintensität gegenüber einem gleichen Ausgangsmaterial, das über einen klassischen Mahlprozess gefinisht wurde.

Darüber hinaus konnte nachgewiesen werden, dass eine Solarzelle, die mit einem Kupferphthalocyanin bedampft war, das entsprechend dem obigen Ausführungsbeispiel erhalten wurde, dieselbe Spannung aufwies, wie eine Solarzelle, die mit einem Kupferphthalocyanin bedampft war, das ausgehend von derselben Ausgangssubstanz erhalten wurde, die jedoch nach einem diskontinuierlichen Reinigungsverfahren nach dem Stand der Technik, in einem Gradientenofen unter einem Vakuum von 10⁻⁴ mbar und hoher Verweilzeit, von 4 Stunden, aufgereinigt wurde.

Das erfindungsgemäße Aufreinigungsverfahren hat gegenüber der Aufreinigung im Gradientenofen nach dem Stand der Technik darüber hinaus auch den weiteren wesentlichen Vorteil, dass es kontinuierlich, und somit scale up-fähig ist, wogegen die Aufreinigung im Gradientenofen diskontinuierlich ist.

## Patentansprüche

1. Verfahren zur kontinuierlichen Reinigung eines Feststoffgemisches, enthaltend ein sublimierbares Wertprodukt, sowie demgegenüber leichter und schwerer sublimierbare Komponenten durch fraktionierte Sublimation/Desublimation in einem Heißwandrohrofen (1), mit Zuführen des Feststoffgemisches zusammen mit einem Inertgasstrom, in den das Feststoffgemisch über ein Dispergierorgan (2) dispergiert wird, an einem Ende des Heißwandrohrofens (1),
- Aufheizen des dispergierten Feststoffgemisches im Heißwandrohrofen (1) bei einer Temperatur, bei der das Wertprodukt sublimiert, unter Erhalt eines Gasgemisches, enthaltend schwerer als das Wertprodukt sub-limierende Komponenten als Feststoffpartikel,
- Überleiten des Gasgemisches, enthaltend schwerer als das Wertprodukt sublimierende Komponenten als Feststoffpartikel über einen Heißgasfilter (3) mit geeigneter Porengröße, um die schwerer als das Wertprodukt sublimierenden Feststoffpartikel zurückzuhalten,
- Abkühlen des Gasgemisches, aus dem die schwerer als das Wertprodukt sublimierenden Komponenten abgetrennt wurden auf eine Temperatur, bei der das Wertprodukt desublimiert, und bei der die leichter als das Wertprodukt sublimierenden Komponenten noch nicht desublimieren, unter Erhalt eines Gasgemisches, enthaltend das partikelförmige Wertprodukt und
- Abscheiden des gereinigten, partikelförmigen Wertproduktes aus dem abgekühlten Gasgemisch.

2. Verfahren nach Anspruch 1, **dadurch gekennzeichnet, dass** das gereinigte partikelförmige Wertprodukt mit einer mittleren Partikelgröße < 10 µm erhalten wird.

3. Verfahren nach Anspruch 1 oder Anspruch 2, **dadurch gekennzeichnet, dass** der Heißwandrohrofen (1) ein Mehrzonenheißwandrohrofen ist.

4. Verfahren nach einem der Ansprüche 1 bis 3, **dadurch gekennzeichnet, dass** das sublimierbare Wertprodukt ein organischer Feststoff ist.

5. Verfahren nach Anspruch 4, **dadurch gekennzeichnet, dass** der organische Feststoff in Electronic-Grade-Reinheit erhalten wird.

6. Verfahren nach Anspruch 5, **dadurch gekennzeichnet, dass** der organische Feststoff in Electronic-Grade-Reinheit ein Pigment ist.

7. Verfahren nach einem der Ansprüche 1 bis 6, **dadurch gekennzeichnet, dass** der Druck am Austritt aus dem Heißwandrohrofen (1) etwa 1 bar absolut beträgt und die Verweilzeit des zu reinigenden Feststoffgemisches im Heißwandrohrofen (1) im Bereich von 0,1 bis 1 Stunde, bevorzugt im Bereich von 0,1 bis 100 Sekunden, weiter bevorzugt im Bereich von 0,5 bis 5 Sekunden, liegt.

8. Verfahren nach einem der Ansprüche 1 bis 7, **dadurch gekennzeichnet, dass** das Dispergierorgan (2) eine Dosierrinne, eine Zellenradschleuse, ein Bürstenzudosierer oder eine Spiralstrahlmühle ist.

9. Verfahren nach einem der Ansprüche 1 bis 8, **dadurch gekennzeichnet, dass** der Heißwandrohrofen (1) elektrisch an seinem Außenmantel beheizt ist.

10. Verfahren nach einem der Ansprüche 3 bis 8, **dadurch gekennzeichnet, dass** der Heißwandrohrofen (1) an seinem Außenmantel elektrisch beheizt ist und zwei, drei oder mehrere Heizzonen aufweist.

11. Verfahren nach einem der Ansprüche 1 bis 10, **dadurch gekennzeichnet, dass** das Aufheizen des dispergierten Feststoffgemisches bis annähernd in den Sublimationsbereich oder annähernd bis zum Sublimationspunkt des Wertproduktes, bevorzugt bis auf etwa 5°C oberhalb oder unterhalb des Sublimationsbereiches oder oberhalb oder unterhalb des Sublimationspunktes des Wertproduktes, erfolgt.

12. Verfahren nach einem der Ansprüche 1 bis 11, **dadurch gekennzeichnet, dass** der Heißgasfilter (3) aus Metall, Keramik, Glasfasern oder aus Kunststoff gebildet ist.

13. Verfahren nach einem der Ansprüche 1 bis 12, **dadurch gekennzeichnet, dass** das Abkühlen des Gasgemisches, enthaltend schwerer als das Wertprodukt sublimierende Komponenten als Feststoffpartikel bei einer Verweilzeit < als 0,1 s bis < 100 s, erfolgt.

14. Verfahren nach einem der Ansprüche 1 bis 13, **dadurch gekennzeichnet, dass** das Abkühlen des Gasgemisches, enthaltend schwerer als das Wertprodukt sublimierende Komponenten als Feststoffpartikel über einen Gasquench oder eine Laval-Düse erfolgt.

15. Verfahren nach einem der Ansprüche 1 bis 14, **dadurch gekennzeichnet, dass** das Abscheiden des gereinigten, partikelförmigen Wertproduktes in einem Elektrofilter erfolgt.

16. Verfahren nach einem der Ansprüche 1 bis 15, **gekennzeichnet durch** einen weiteren Verfahrensschritt, wonach aus dem gereinigten, partikelförmigen Wertprodukt Leichtsieder **durch** fraktionierte Sublimation/Desublimation abgetrennt werden.

17. Verfahren nach einem der Ansprüche 1 bis 16, **dadurch gekennzeichnet, dass** die Abkühlung des Gasgemisches, enthaltend schwerer als das Wertprodukt sublimierende Komponenten als Feststoffpartikel auf eine Temperatur, bei der das Wertprodukt in Gegenwart von inerten Trägerpartikeln erfolgt, wobei die inerten Trägerpartikel bevorzugt kugelförmig sind und weiter bevorzugt einen Durchmesser im einstelligen Millimeterbereich aufweisen.

18. Verfahren nach Anspruch 17, **dadurch gekennzeichnet, dass** die Abkühlung bei einer Temperatur und einem Druck erfolgt, die so geregelt werden, dass sich auf den inerten Trägerpartikeln eine Feststoffschicht des Wertproduktes, bevorzugt mit einer Dicke im Bereich von 1 bis 200 µm, abscheidet.

19. Heißwandrohrofen (1) zur kontinuierlichen Reinigung eines Feststoffgemisches, umfassend ein Wertprodukt, demgegenüber leichter und schwerer sublimierbare Komponenten durch fraktionierte Desublimation/Sublimation
- mit einem Zuführstutzen für das Zuführen des Feststoffgemisches zusammen mit einem Inertgasstrom, in den das Feststoffgemisch über ein Dispergierorgan (2) dispergiert wird, an einem Ende des Heißwandrohrofens (1),
- 1, 2, 3 oder mehreren Heizzonen zum Aufheizen des dispergierten Feststoffgemisches im Heißwandrohrofen (1) bei einer Temperatur, bei der das Wertprodukt sublimiert, unter Erhalt eines Gasgemisches, enthaltend schwerer als das Wertprodukt sublimierende Komponenten als Partikel,
- einem Heißgasfilter (3) mit geeigneter Porengröße zum Überleiten des Gasgemisches, enthaltend schwerer als das Wertprodukt sublimierende Komponenten als Partikel, um die schwerer als der Wertstoff sublimierenden Partikel zurückzuhalten, und mit
- einem Gasquench, einer Laval-Düse oder einem Verweilzeitbehälter zum Abkühlen des Gasgemisches, enthaltend schwerer als das Wertprodukt sublimierende Komponenten als Partikel auf eine Temperatur, bei der das Wertprodukt desublimiert, unter Erhalt des gereinigten, partikelförmigen Wertproduktes.

20. Heißwandrohrofen (1) nach Anspruch 19, **dadurch gekennzeichnet, dass** das Dispergierorgan (2) eine Dosierrinne, eine Zellenradschleuse, ein Bürstenzudosierer oder eine Spiralstrahlmühle ist.

21. Heißwandrohrofen (1) nach Anspruch 19 oder 20, **dadurch gekennzeichnet, dass** er elektrisch an seinem Außenmantel beheizt ist.

22. Heißwandrohrofen (1) nach einem der Ansprüche 19 bis 21, **dadurch gekennzeichnet, dass** der Heißgasfilter (3) aus Metall, Keramik, Glasfasern oder Kunststoff gebildet ist.

## Claims

1. A process for continuously purifying a solid mixture comprising a sublimable product of value and components with lower and higher sublimation temperatures by fractional sublimation/desublimation in a hot wall tubular oven (1) with supply of the solid mixture together with an inert gas stream, into which the solid mixture is dispersed by means of a dispersing unit (2), at one end of the hot wall tubular oven (1),
- heating the dispersed solid mixture in the hot wall tubular oven (1) at a temperature at which the product of value sublimes to obtain a gas mixture comprising components with a higher sublimation temperature than the product of value as solid particles,
- passing the gas mixture comprising components with a higher sublimation temperature than the product of value as solid particles through a hot gas filter (3), arranged in a section of the hot wall tubular oven (1), with a suitable pore size in order to retain the solid particles with a higher sublimation temperature than the product of value,
- cooling the gas mixture from which the components with a higher sublimation temperature than the product of value have been removed to a temperature at which the product of value desublimes, and at which the components with a lower sublimation temperature than the product of value are yet to desublime, to obtain a gas mixture comprising the particulate product of value and
- separating the purified particulate product of value from the cooled gas mixture.

2. The process according to claim 1, wherein the purified particulate product of value is obtained with a mean particle size of < 10 µm.

3. The process according to claim 1 or claim 2, wherein the hot wall tubular oven (1) is a multizone hot wall tubular oven.

4. The process according to any one of claims 1 to 3, wherein the sublimable product of value is an organic solid.

5. The process according to claim 4, wherein the organic solid is obtained in electronics grade purity.

6. The process according to claim 5, wherein the organic solid in electronics grade purity is a pigment.

7. The process according to any one of claims 1 to 6, wherein the pressure at the exit from the hot wall tubular oven (1) is about 1 bar absolute and the residence time of the solid mixture to be purified in the hot wall tubular oven (1) is in the range from 0.1 to 1 hour, preferably in the range from 0.1 to 100 seconds, more preferably in the range from 0.5 to 5 seconds.

8. The process according to any one of claims 1 to 7, wherein the dispersing unit (2) is a dosage channel, a star feeder, a brush feeder or a spiral jet mill.

9. The process according to any one of claims 1 to 8, wherein the hot wall tubular oven (1) is electrically heated on its outer jacket.

10. The process according to any one of claims 3 to 8, wherein the hot wall tubular oven (1) is electrically heated on its outer jacket and has two, three or more heating zones.

11. The process according to any one of claims 1 to 10, wherein the disperse solid mixture is heated up to close to the sublimation range or close to the sublimation point of the product of value, preferably to about 5°C above or below the sublimation range or above or below the sublimation point of the product of value.

12. The process according to any one of claims 1 to 11, wherein the hot gas filter (3) is formed from metal, ceramic, glass fibers or from plastic.

13. The process according to any one of claims 1 to 12, wherein the gas mixture comprising components with a higher sublimation temperature than the product of value as solid particles is cooled for a residence time of < 0.1 s to < 100 s.

14. The process according to any one of claims 1 to 13, wherein the gas mixture comprising components with a higher sublimation temperature than the product of value as solid particles is cooled by means of a gas quench or a Laval nozzle.

15. The process according to any one of claims 1 to 14, wherein the purified particulate product of value is deposited in an electrofilter.

16. The process according to any one of claims 1 to 15, **characterized by** a further process step by which low boilers are removed by fractional sublimation/desublimation from the purified particulate product of value.

17. The process according to any one of claims 1 to 16, wherein the gas mixture comprising components with a higher sublimation temperature than the product of value as solid particles are cooled to a temperature at which the product of value desublimes in the presence of inert carrier particles, said inert carrier particles preferably being spherical and more preferably having a diameter in the single-digit millimeter range.

18. The process according to claim 17, wherein the cooling is effected at a temperature and a pressure which are controlled so as to deposit, on the inert carrier particles, a solid layer of the product of value, preferably with a thickness in the range from 1 to 200 µm.

19. A hot wall tubular oven (1) for continuously purifying a solid mixture comprising a product of value and components with lower and higher sublimation temperatures by fractional desublimation/sublimation
- with a supply nozzle for the supply of the solid mixture together with an inert gas stream into which the solid mixture is dispersed by means of a dispersing unit (2), at one end of the hot wall tubular oven (1),
- 1, 2, 3 or more heating zones for heating the dispersed solid mixture in the hot wall tubular oven (1) at a temperature at which the product of value sublimes to obtain a gas mixture comprising components with a higher sublimation temperature than the product of value as particles,
- a hot gas filter (3) arranged in a section of the hot wall tubular oven (1), with a suitable pore size for passage of the gas mixture comprising components with a higher sublimation temperature than the product of value as particles in order to retain the particles with a higher sublimation temperature than the substance of value, and comprising
- a gas quench, a Laval nozzle or a delay vessel for cooling the gas mixture comprising components with a higher sublimation temperature than the product of value as particles to a temperature at which the product of value desublimes to obtain the purified particulate product of value.

20. The hot wall tubular oven (1) according to claim 19, wherein the dispersing unit (2) is a dosage channel, a star feeder, a brush feeder or a spiral jet mill.

21. The hot wall tubular oven (1) according to claim 19 or 20, which is electrically heated on its outer jacket.

22. The hot wall tubular oven (1) according to any one of claims 19 to 21, wherein the hot gas filter (3) is formed from metal, ceramic, glass fibers or plastic.

## Revendications

1. Procédé de purification continue d'un mélange solide, contenant un produit de valeur sublimable, ainsi que des composants plus faciles et plus difficiles à sublimer que celui-ci, par sublimation/désublimation fractionnée dans un four tubulaire à paroi chauffante (1), comprenant l'introduction du mélange solide conjointement avec un courant de gaz inerte, dans lequel le mélange solide est dispersé par un organe de dispersion (2), à une extrémité du four tubulaire à paroi chauffante (1),
- le chauffage du mélange solide dispersé dans le four tubulaire à paroi chauffante (1) à une température à laquelle le produit de valeur est sublimé, pour obtenir un mélange gazeux contenant des composants plus difficiles à sublimer que le produit de valeur sous la forme de particules solides,
- le passage du mélange gazeux contenant des composants plus difficiles à sublimer que le produit de valeur sous la forme de particules solides sur un filtre à gaz chaud (3), qui est agencé dans une section du four tubulaire à paroi chauffante (1), présentant une taille de pore appropriée pour retenir les particules solides plus difficiles à sublimer que le produit de valeur,
- le refroidissement du mélange gazeux duquel les composants plus difficiles à sublimer que le produit de valeur ont été séparés à une température à laquelle le produit de valeur est désublimé et à laquelle les composants plus faciles à sublimer que le produit de valeur ne sont pas encore désublimés, pour obtenir un mélange gazeux contenant le produit de valeur particulaire, et
- la séparation du produit de valeur particulaire purifié du mélange gazeux refroidi.

2. Procédé selon la revendication 1, **caractérisé en ce que** le produit de valeur particulaire purifié est obtenu en une taille de particule moyenne < 10 µm.

3. Procédé selon la revendication 1 ou la revendication 2, **caractérisé en ce que** le four tubulaire à paroi chauffante (1) est un four tubulaire à paroi chauffante à zones multiples.

4. Procédé selon l'une quelconque des revendications 1 à 3, **caractérisé en ce que** le produit de valeur sublimable est un solide organique.

5. Procédé selon la revendication 4, **caractérisé en ce que** le solide organique est obtenu en une pureté de niveau électronique.

6. Procédé selon la revendication 5, **caractérisé en ce que** le solide organique de pureté de niveau électronique est un pigment.

7. Procédé selon l'une quelconque des revendications 1 à 6, **caractérisé en ce que** la pression à la sortie du four tubulaire à paroi chauffante (1) est d'environ 1 bar absolu et le temps de séjour du mélange solide à purifier dans le four tubulaire à paroi chauffante (1) est dans la plage allant de 0,1 à 1 heure, de préférence dans la plage allant de 0,1 à 100 secondes, de manière davantage préférée dans la plage allant de 0,5 à 5 secondes.

8. Procédé selon l'une quelconque des revendications 1 à 7, **caractérisé en ce que** l'organe de dispersion (2) est un conduit de dosage, une vanne rotative, un dispositif de dosage à brosse ou un broyeur à jet en spirale.

9. Procédé selon l'une quelconque des revendications 1 à 8, **caractérisé en ce que** le four tubulaire à paroi chauffante (1) est chauffé électriquement au niveau de son enveloppe extérieure.

10. Procédé selon l'une quelconque des revendications 3 à 8, **caractérisé en ce que** le four tubulaire à paroi chauffante (1) est chauffé électriquement au niveau de son enveloppe extérieure et comprend deux, trois zones de chauffage ou plus.

11. Procédé selon l'une quelconque des revendications 1 à 10, **caractérisé en ce que** le chauffage du mélange solide dispersé a lieu presque jusqu'à la plage de sublimation ou presque jusqu'au point de sublimation du produit de valeur, de préférence jusqu'à environ 5 °C au-dessus ou en dessous de la plage de sublimation ou au-dessus ou en dessous du point de sublimation du produit de valeur.

12. Procédé selon l'une quelconque des revendications 1 à 11, **caractérisé en ce que** le filtre à gaz chaud (3) est formé en métal, en céramique, en fibres de verre ou en plastique.

13. Procédé selon l'une quelconque des revendications 1 à 12, **caractérisé en ce que** le refroidissement du mélange gazeux contenant des composants plus difficiles à sublimer que le produit de valeur sous la forme de particules solides a lieu pendant un temps de séjour de < 0,1 s à < 100 s.

14. Procédé selon l'une quelconque des revendications 1 à 13, **caractérisé en ce que** le refroidissement du mélange gazeux contenant des composants plus difficiles à sublimer que le produit de valeur sous la forme de particules solides a lieu par une trempe en atmosphère gazeuse ou par une buse de Laval.

15. Procédé selon l'une quelconque des revendications 1 à 14, **caractérisé en ce que** la séparation du produit de valeur particulaire purifié a lieu dans un électro-filtre.

16. Procédé selon l'une quelconque des revendications 1 à 15, **caractérisé par** une étape de procédé supplémentaire, selon laquelle des composés de point d'ébullition faible sont séparés du produit de valeur particulaire purifié par sublimation/désublimation fractionnée.

17. Procédé selon l'une quelconque des revendications 1 à 16, **caractérisé en ce que** le refroidissement du mélange gazeux contenant des composants plus difficiles à sublimer que le produit de valeur sous la forme de particules solides a lieu à une température à laquelle le produit de valeur est désublimé, en présence de particules supports inertes, les particules supports inertes étant de préférence sphériques et présentant de manière davantage préférée un diamètre dans la plage millimétrique à un chiffre.

18. Procédé selon la revendication 17, **caractérisé en ce que** le refroidissement a lieu à une température et à une pression qui sont ajustées de manière à ce qu'une couche solide du produit de valeur, de préférence d'une épaisseur dans la plage allant de 1 à 200 µm, se dépose sur les particules supports inertes.

19. Four tubulaire à paroi chauffante (1) pour la purification continue d'un mélange solide, comprenant un produit de valeur, des composants plus faciles et plus difficiles à sublimer que celui-ci, par désublimation/sublimation fractionnée
- comprenant un raccord d'alimentation pour l'alimentation du mélange solide conjointement avec un courant de gaz inerte, dans lequel le mélange solide est dispersé par un organe de dispersion (2), à une extrémité du four tubulaire à paroi chauffante (1),
- 1, 2, 3 zones de chauffage ou plus pour le chauffage du mélange solide dispersé dans le four tubulaire à paroi chauffante (1) à une température à laquelle le produit de valeur est sublimé, pour obtenir un mélange gazeux contenant des composants plus difficiles à sublimer que le produit de valeur sous la forme de particules,
- un filtre à gaz chaud (3), qui est agencé dans une section du four tubulaire à paroi chauffante (1), présentant une taille de pore appropriée pour le passage du mélange gazeux contenant des composants plus difficiles à sublimer que le produit de valeur sous la forme de particules, afin de retenir les particules plus difficiles à sublimer que la substance de valeur, et comprenant
- une trempe en atmosphère gazeuse, une buse de Laval ou un contenant à temps de séjour pour le refroidissement du mélange gazeux contenant des composants plus difficiles à sublimer que le produit de valeur sous la forme de particules, à une température à laquelle le produit de valeur est désublimé, pour obtenir le produit de valeur particulaire purifié.

20. Four tubulaire à paroi chauffante (1) selon la revendication 19, **caractérisé en ce que** l'organe de dispersion (2) est un conduit de dosage, une vanne rotative, un dispositif de dosage à brosse ou un broyeur à jet en spirale.

21. Four tubulaire à paroi chauffante (1) selon la revendication 19 ou 20, **caractérisé en ce qu'**il est chauffé électriquement au niveau de son enveloppe extérieure.

22. Four tubulaire à paroi chauffante (1) selon l'une quelconque des revendications 19 à 21, **caractérisé en ce que** le filtre à gaz chaud (3) est formé en métal, en céramique, en fibres de verre ou en plastique.
